# FASCICULE DE BREVET EUROPEEN

(11) **EP 4 142 458 B1**
(45) Date de publication et mention de la délivrance du brevet: **27.03.2024**
(21) Numéro de dépôt: 22191909.5
(22) Date de dépôt: 24.08.2022
(51) Int. Cl.: H10N 60/01, H10N 60/10

(54) **PROCÉDÉ DE RÉALISATION D'UN SILICIURE DE VANADIUM SUPRACONDUCTEUR SUR UNE COUCHE DE SILICIUM**
VERFAHREN ZUR HERSTELLUNG EINES SUPRALEITENDEN VANADIUMSILIZIDS AUF EINER SILIZIUMSCHICHT
METHOD FOR PRODUCING A SUPERCONDUCTING VANADIUM SILICIDE ON A SILICON LAYER

(30) Priorité: 31.08.2021 FR 2109112
(43) Date de publication de la demande: 01.03.2023
(73) Titulaire: Commissariat à l'Energie Atomique et aux Energies Alternatives, 75015 Paris (FR); Université Grenoble Alpes, 38400 Saint-Martin-d'Hères (FR)
(72) Inventeur: NEMOUCHI, Fabrice, 38054 Grenoble Cedex 09 (FR); FARJOT, Thierry, 38054 Grenoble Cedex 09 (FR); GUSTAVO, Frédéric, 38054 Grenoble Cedex 09 (FR); LEFLOCH, François, 38054 Grenoble Cedex 09 (FR); VETHAAK, Tom, 38000 Grenoble (FR)
(74) Mandataire: INNOV-GROUP

(56) Documents cités:
- FR-A1- 3 088 483
- JP-A- S57 153 481
- US-A- 4 495 510
- US-A1- 2020 287 119
- TOM DOEKLE VETHAAK ET AL: "Influence of substrate-induced thermal stress on the superconducting properties of V3Si thin films", ARXIV.ORG, CORNELL UNIVERSITY LIBRARY, 201 OLIN LIBRARY CORNELL UNIVERSITY ITHACA, NY 14853, 14 octobre 2020 (2020-10-14), XP081890742, DOI: 10.1063/5.0038638
- TOM DOEKLE VETHAAK ET AL: "Superconducting V_3Si for quantum circuit applications", ARXIV.ORG, CORNELL UNIVERSITY LIBRARY, 201 OLIN LIBRARY CORNELL UNIVERSITY ITHACA, NY 14853, 1 avril 2021 (2021-04-01), XP081931431,
- CHU W K ET AL: "Implanted noble gas atoms as diffusion markers in silicide formation", THIN SOLID FILMS, ELSEVIER, AMSTERDAM, NL, vol. 25, no. 2, 1 février 1975 (1975-02-01), pages 393-402, XP025703218, ISSN: 0040-6090, DOI: 10.1016/0040-6090(75)90057-7 [extrait le 1975-02-01]

## Description

L'invention concerne un procédé de réalisation d'un siliciure de vanadium supraconducteur sur une couche de silicium.

Dans cette description le siliciure de vanadium supraconducteur désigne le matériau dont la formule chimique est V₃Si et non pas le matériau dont la formule chimique est VSi₂.

Le siliciure de vanadium est l'un des siliciures supraconducteurs qui présente la température critique la plus élevée. En effet, sa température critique peut atteindre 17 K pour un matériau massif. La température critique désigne la température du matériau supraconducteur en dessous laquelle sa résistivité est nulle ou pratiquement nulle.

La réalisation de siliciure de vanadium supraconducteur en couche mince sur une couche en silicium est intéressant dans plusieurs domaines techniques dont celui de la microélectronique quantique et, en particulier, dans le domaine des ordinateurs quantiques. Il est notamment très intéressant pour la fabrication de jonctions de Josephson.

Par exemple, la demande US2020287119A1 décrit un procédé de fabrication d'un composant à jonction Josephson dans lequel des électrodes en matériau supraconducteur, comme le siliciure de vanadium, sont réalisées sur une couche de silicium. Pour réaliser les électrodes en siliciure de vanadium supraconducteur, cette demande de brevet enseigne qu'il faut d'abord déposer une couche de vanadium pur sur la couche de silicium. Ensuite, la couche de vanadium et la couche de silicium sont chauffées à une température suffisamment élevée et pendant un temps suffisamment long pour que le vanadium soit transformé en siliciure de vanadium. Cette transformation consomme une partie de la couche en silicium.

Ce procédé de réalisation d'un siliciure de vanadium supraconducteur sur une couche de silicium présente plusieurs inconvénients. Par exemple, il consomme beaucoup de vanadium. Il est plus complexe et comporte plus d'étapes. Le dépôt de la couche de vanadium sur la couche en silicium est complexe. Il est difficile d'obtenir une épaisseur précise de siliciure de vanadium ou de contrôler une interface abrupte. De plus, la couche de siliciure de vanadium n'est pas thermodynamiquement stable sur le silicium. Elle réagit avec le silicium en excès pour former une phase VSi₂ qui ne présente pas propriété supraconductrice autour de 500 °C.

L'invention vise à remédier à au moins l'un de ces inconvénients. Elle a donc pour objet un procédé de réalisation d'un siliciure de vanadium supraconducteur sur une couche de silicium conforme à la revendication 1. Elle a également pour objet un procédé de fabrication d'un transistor mettant en oeuvre ce procédé de réalisation d'un siliciure de vanadium.

L'invention sera mieux comprise à la lecture de la description qui va suivre, donnée uniquement à titre d'exemple non limitatif et faite en se référant aux dessins sur lesquels :
- la figure 1 est un organigramme d'un procédé de fabrication d'un transistor au cours duquel un siliciure de vanadium supraconducteur est réalisé sur une couche en silicium ;
- les figures 2 à 9 sont des illustrations schématiques, en coupe verticale, de différents états de fabrication du transistor lors de la mise en oeuvre du procédé de la figure 1 ;
- la figure 10 est une images d'une coupe du siliciure de vanadium obtenu selon les principales étapes du procédé de la figure 1, et
- la figure 11 est une image d'une coupe de siliciure de vanadium obtenu selon un procédé alternatif à celui mis en oeuvre pour réaliser le siliciure de vanadium de la figure 10.

Dans ces figures, les mêmes références sont utilisées pour désigner les mêmes éléments. Dans la suite de cette description, les caractéristiques et fonctions bien connues de l'homme du métier ne sont pas décrites en détail.

Dans cette description des exemples détaillés de modes de réalisation sont d'abord décrits dans un chapitre I en référence aux figures. Ensuite, dans un chapitre II, des variantes de ces modes de réalisation sont présentées. Enfin, les avantages des différents modes de réalisation sont présentés dans un chapitre III.

### Chapitre I - Exemples de mode de réalisation :

Le procédé de réalisation d'un siliciure de vanadium supraconducteur sur une couche de silicium va maintenant être décrit dans le cas particulier d'un procédé de fabrication d'un transistor, et plus précisément d'un transistor à effet de champ Josephson plus connu sous l'acronyme JoFET (« Josephson Field Effect Transistor »). De tels transistors sont, par exemple, utilisés pour fabriquer des ordinateurs quantiques, des SQUID (Superconducting QUantum Interference Device), des amplificateurs à la limite quantique et autres. Toutefois, l'enseignement donné dans ce cas particulier s'applique à tout autre composant dans lequel du siliciure de vanadium supraconducteur doit être réalisé sur une couche de silicium. De tels exemples d'autres composants sont donnés dans le chapitre III à la fin de cette description.

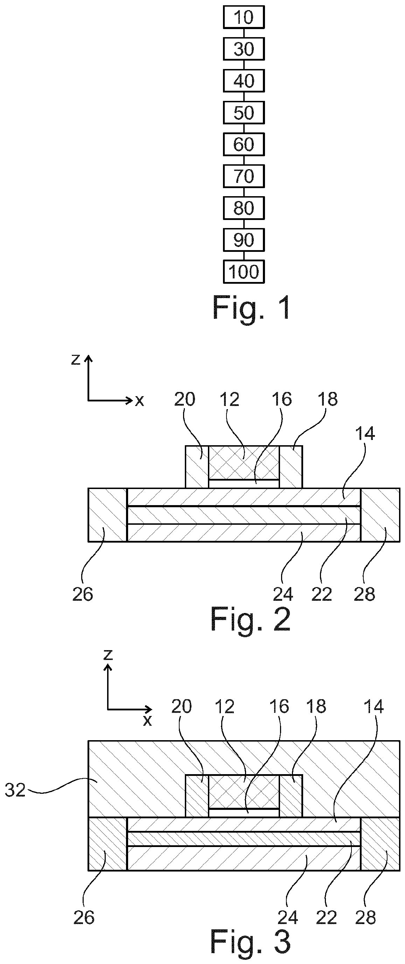

Les figures 2 à 9 représentent différents états de fabrication du transistor. Sur ces figures, les épaisseurs des différentes couches ne sont pas à l'échelle pour faciliter leur lecture. Sur ces figures, les différentes couches s'étendent principalement horizontalement. Les directions horizontales sont représentées par deux directions X et Y d'un repère orthogonal XYZ. La direction Z est la direction verticale. Ici, la direction Y est perpendiculaire au plan de la feuille et n'a pas été représentée. Les termes tels que « supérieur », « inférieur », « dessus », « dessous » et similaires sont définis par rapport à cette direction Z.

Par la suite, l'expression "un élément réalisé en X" ou "élément en X" ou "élément de X" signifie qu'au moins 90 % de la masse de cet élément et, de préférence, au moins 95 % ou 98 % de la masse de cet élément est formé par le matériau X.

Lors d'une étape 10, une grille 12 (figure 2) du transistor est réalisée sur une couche 14 de silicium. La grille 12 est réalisée dans un matériau électriquement conducteur ou en matériau semiconducteur. Ici, l'expression « matériau électriquement conducteur » désigne un matériau dont la conductivité électrique à 20 °C est supérieure à 10² S/m et, de préférence, supérieure à 10⁵ S/m. Par exemple, ici, la grille 12 est réalisée en silicium polycristallin dopé (de type n ou p). La grille 12 peut aussi être réalisée par un empilement de métaux ou d'alliage ayant ou non des propriétés supraconductrices.

La grille 12 est électriquement isolée de la couche 14 par une fine couche en matériau électriquement isolant. Ici, un matériau électriquement isolant est un matériau dont la conductivité électrique à 20 °C est inférieur à 10⁻⁷ ou 10⁻¹¹ S/m. Par exemple, la couche 16 est réalisée en oxyde de silicium ou en oxydes métalliques ayant une haute permittivité (connue sous le nom de « high k » en anglais) ou en silicate.

Les faces verticales de la grille 12 sont isolées de l'extérieur par des espaceurs 18, 20. Les espaceurs 18, 20 sont réalisés dans un matériau électriquement isolant comme du nitrure de silicium ou de l'oxyde de silicium ou un empilement de ceux-ci.

De préférence, la couche 14 est réalisée en silicium monocristallin. Une face supérieure de cette couche 14 est directement en contact avec une face inférieure de la couche 16. L'épaisseur de la couche 14 est généralement comprise entre 5 nm et 500 nm et, de préférence, comprise entre 5 nm et 50 nm ou entre 7 nm et 30 nm. La face inférieure de la couche 14 s'étend directement sur une couche 22 en matériau électriquement isolant.

La couche 22 est typiquement réalisée en oxyde de silicium. Son épaisseur est par exemple comprise entre 1 nm et 150 nm. La couche 22 peut aussi être omise.

La couche 22 repose directement sur un support 24 qui rigidifie les différentes couches qui sont empilées dessus. Par exemple, l'épaisseur du support 24 est supérieure à 10 µm et, typiquement, supérieure à 500 µm ou 700 µm. Ici, ce support 24 est réalisé en silicium tel que du silicium monocristallin, amorphe ou polycristallin. Typiquement, le support 24 et les couches 22 et 14 correspondent aux trois couches d'un substrat SOI (« Silicon On Insulator »).

Pour isoler le transistor des autres transistors fabriqués en parallèle sur le même support 24, des tranchées 26 et 28 d'isolation profonde sont réalisées autour du transistor à fabriquer. Ces tranchées 26 et 28 sont connues sous l'acronyme STI (« Shallow Trench Isolation »). Elles sont réalisées dans un matériau électriquement isolant tel que de l'oxyde de silicium ou du nitrure et de l'oxyde de silicium. La profondeur des tranchées 26 et 28 est typiquement de l'ordre de 250 nm. Ainsi, la profondeur de ces tranchées est généralement comprise entre 200 nm et 300 nm. Par "profondeur des tranchées 26 et 28" on désigne ici la plus grande dimension des tranchées 26 et 28 dans une direction perpendiculaire au plan dans lequel s'étant principalement le support 24. Les différentes étapes pour obtenir, à partir d'un substrat SOI, l'état représenté sur la figure 2, sont connues. Ainsi, l'étape 10 n'est pas décrite ici plus en détail.

Lors d'une étape 30, une couche 32 (figure 3) de matériau électriquement isolant est déposée sur la face supérieure de la couche 14 pour encapsuler complètement la grille 12 à l'intérieur de cette couche 32. Ici, la couche 32 est réalisée en oxyde de silicium.

Ensuite, la face supérieure de la couche 32 est polie pour obtenir l'état représenté sur la figure 3. Par exemple, le procédé de polissage mis en oeuvre est un procédé de polissage mécano-chimique connu sous l'acronyme CMP (« Chemical-Mechanical Polishing »).

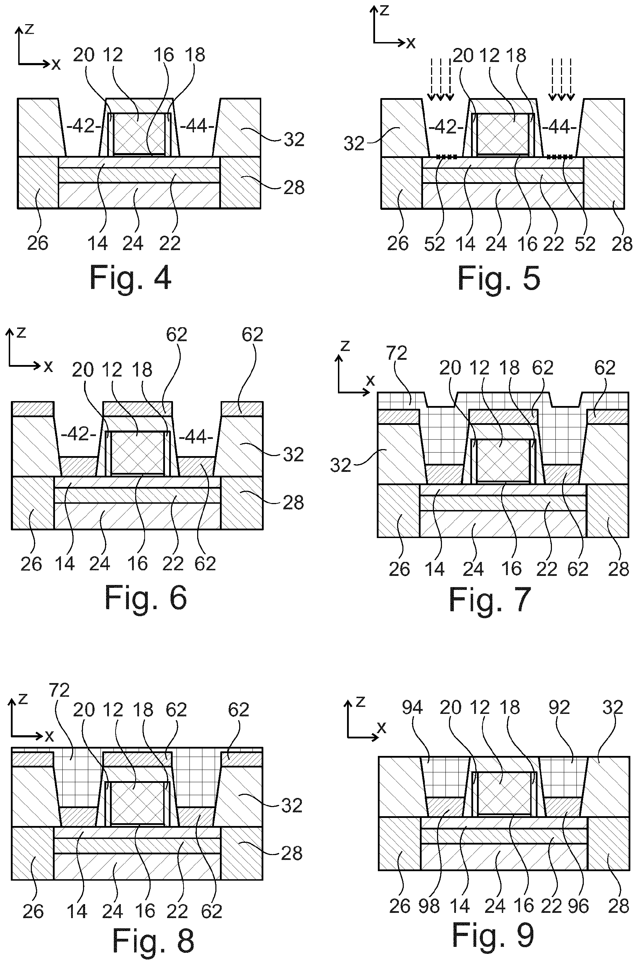

Lors d'une étape 40, des trous 42 et 44 (figure 4) sont creusés de part et d'autre de la grille 12 aux emplacements où doivent être réalisées les électrodes du transistor. Dans le cas d'un transistor JoFET, ces électrodes sont, respectivement, le drain et la source. Les trous 42 et 44 débouchent chacun directement sur la face supérieure de la couche 14. Ainsi, une partie de la face supérieure de la couche 14 est mise à nu par l'intermédiaire de ces trous 42, 44.

Lors d'une étape 50, un traitement de la face supérieure de la couche 14 mise à nu est réalisé pour la préparer à recevoir un dépôt de siliciure de vanadium. Ici, la préparation de la face supérieure de la couche 14 mise à nu consiste à incorporer des atomes d'argon 52 (figure 5) en surface de cette couche 14, ainsi qu'à nettoyer la face supérieure de cette couche pour, notamment, la désoxyder.

Sur la figure 5, les atomes d'argon incorporés dans la couche 14 sont représentés par des croix et désignés par la même référence commune 52. La majorité des atomes d'argon incorporés dans la couche 14 se situent à moins 10 nm et, de préférence, à moins de 5 nm de la face supérieure de la couche 14. Ils se situent donc à l'intérieur d'une région qui correspond à une fine couche superficielle de moins de 10 nm et, de préférence, de moins de 5 nm d'épaisseur. L'épaisseur de cette fine couche superficielle est aussi généralement supérieure à 1 nm. Avantageusement, 70 % ou 80 % ou même 90 % en masse des atomes d'argon incorporés dans la couche 14 se situent à l'intérieur de cette fine couche superficielle. La concentration d'atomes d'argon incorporés dans cette fine couche superficielle est comprise entre 1 % atomique et 10 % atomique et, de préférence, entre 2 % atomique et 5 % atomique. L'expression "X % atomique" signifie que le nombre d'atomes d'argon à l'intérieur de la fine couche superficielle représente X % du nombre total d'atomes présents dans cette couche superficielle. Par la suite, le terme "en surface de la couche 14" désigne la fine couche superficielle de la couche 14. L'expression "incorporer des atomes d'argon en surface de la couche 14" signifie incorporer les atomes d'argon à l'intérieur de la fine couche superficielle avec une concentration comprise dans les plages de concentrations précédentes.

Ici, pour incorporer les atomes d'argon en surface de la couche 14 et en même temps nettoyer la face supérieure mise à nu, la face supérieure du transistor en cours de fabrication est soumise à une opération de nettoyage par plasma d'argon. Lors de cette opération, la face supérieure est directement exposée à un plasma d'argon. Ce plasma comporte des ions d'argon. Le transistor et le plasma sont à des potentiels différents de sorte que les ions d'argon sont projetés sur la face supérieure de la couche 14. Ces ions d'argon projetés pénètrent alors faiblement à l'intérieur de la couche 14 puis se transforment en atomes d'argon. Sur la figure 5, la projection des ions d'argon sur la face supérieure de la couche 14 est représentée par des flèches verticales en pointillés.

Pour régler la quantité d'ions d'argon projetés sur la face supérieure mise à nu de la couche 14, il existe principalement deux paramètres à régler pour une différence de potentiels donnée :
- la pression partielle d'argon dans le plasma, et
- la puissance du générateur nécessaire pour obtenir le plasma.

La pression partielle peut être réglée en ajustant le débit de gaz d'argon entrant et sortant du réservoir contenant le plasma d'argon.

La concentration d'ions d'argon dans le plasma peut être ajustée en modifiant la puissance du courant alternatif qui circule dans une antenne qui transforme ce courant alternatif en un champ électrique alternatif présent à l'intérieur du réservoir. C'est ce champ électrique alternatif qui transforme le gaz d'argon inerte en plasma d'argon. Cette puissance est connue sous le terme de « puissance RF ». Ici, la pression partielle et la puissance RF sont réglées pour obtenir la concentration souhaitée d'atomes d'argon à l'intérieur de la fine couche superficielle de la couche 14.

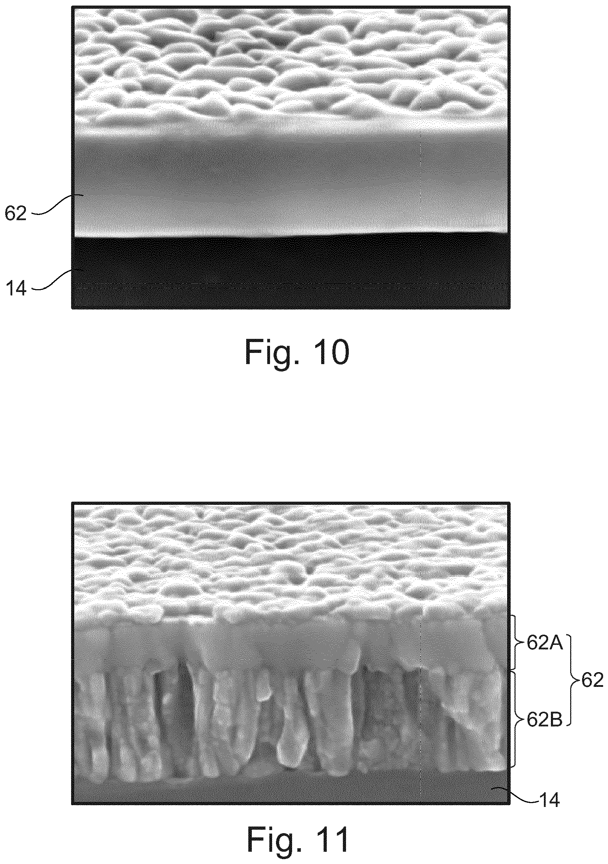

A titre d'exemple, une machine CT200 produite par la société ALLIANCE CONCEPT^{®} a été utilisée. Pour obtenir la concentration souhaitée d'atomes d'argon en surface de la couche 14 avec cette machine, la pression partielle est choisie entre 0.001 mbar (0,1 Pa) et 0.15 mbar (15 Pa) et la puissance RF est choisie entre 100 W et 400 W. Par exemple, une pression égale à 0.05 mbar (5 Pa) et une puissance RF égale à 200 W ont été utilisées pour obtenir la couche de siliciure de vanadium représentée sur la figure 10.

Lors d'une étape 60, une couche 62 de siliciure de vanadium est déposée sur la face supérieure du transistor en cours de fabrication. Une fois déposée, cette couche 62 recouvre principalement les portions de la face supérieure du transistor qui s'étendent horizontalement. En particulier, la couche 62 recouvre le fond des trous 42 et 44. Ainsi, au fond de chaque trou 42 et 44, on obtient un empilement d'une couche de siliciure de vanadium directement déposée sur la couche 14 de silicium. L'épaisseur de la couche 62 est comprise entre 5 nm et 400 nm et, de préférence, entre 5 nm et 100 nm ou entre 5 nm et 60 nm.

Ici, le dépôt de siliciure de vanadium est réalisé selon la méthode de dépôt physique en phase vapeur connue sous l'acronyme PVD ("Physical Vapor Deposition"). Par exemple, pour cela, une cible en siliciure de vanadium est bombardée avec des ions argon, ce qui arrache des atomes à la cible. Les atomes ainsi arrachés viennent ensuite se déposer sur la face supérieure du transistor en cours de fabrication. La couche 62 se dépose ainsi progressivement.

A ce stade, la couche 62 déposée est amorphe ou que partiellement cristallisée. Ainsi, à ce stade, le siliciure de vanadium n'est pas encore supraconducteur ou sa température critique est faible et peut encore être améliorée.

Lors d'une étape 70, une couche métallique 72 (Figure 7) est déposée pour remplir complètement les trous 42 et 44. Par exemple, la couche 72 est réalisée en tungstène.

Lors d'une étape 80, la face supérieure de la couche 72 est polie pour obtenir une face supérieure plane (Figure 8). Ce polissage est arrêté avant d'atteindre la couche 62. Par exemple, il s'agit d'un simple polissage mécanique.

Lors d'une étape 90, un nouveau polissage est mis en oeuvre. Ce polissage est arrêté lorsque la couche 32 est atteinte (Figure 9). Ce polissage élimine donc les portions des couches 62 et 72 qui se trouvent en dehors des trous 42 et 44. On obtient donc deux plots métalliques 92 et 94, un drain 96 en siliciure de vanadium et une source 98 en siliciure de vanadium. Le drain 96 et la source 98 sont chacun formés par une portion restante de la couche 62 située au fond des trous, respectivement, 44 et 42. Le drain 96 et la source 98 sont électriquement raccordés l'un à l'autre par une portion de la couche 14 de silicium appelée "canal". Les plots 92 et 94 raccordent électriquement, respectivement, le drain 96 et la source 98 à une face supérieure du transistor.

Lors d'une étape 100, un recuit, également appelé ici "traitement thermique", est appliqué pour chauffer le siliciure de vanadium déposé et ainsi augmenter sa température critique pour, typiquement, obtenir une température critique supérieure à 10 K et, de préférence, supérieure à 15 K ou 16 K ou 17 K. Pour cela, ce traitement thermique cristallise le siliciure de vanadium déposé lors de l'étape 60.

Ce traitement thermique consiste à placer le transistor dans un four préchauffé à une température prédéterminée ou dans un four non préchauffé puis porté à une température TF comprise entre 200 °C et 1100 °C et, de préférence, comprise entre 500 °C et 900 °C.

Ensuite, le transistor est laissé dans ce four pendant une durée DF comprise entre 10 s et 15 min et, préférentiellement, comprise entre ou entre 10 s et 5 min et encore plus préférentiellement comprise entre 10 s et 120 s ou entre 30 s et 60 s. Typiquement, plus la température TF est élevée, plus la durée DF peut être réduite. Toutefois, une température TF trop élevée peut endommager ou modifier d'autres couches du transistor comme le support 14. Ainsi, un compromis acceptable doit être trouvé entre une température TF élevée et une durée DF courte. Un compromis acceptable est, par exemple, de choisir la température TF entre 500 °C et 900 °C et la durée DF entre 30 s et 60 s.

Par exemple, lors de l'étape 100, le traitement thermique est un recuit thermique rapide plus connu sous l'acronyme RTA ("Rapid Thermal Annealing").

La figure 10 représente une vue en coupe de la couche 62 sur la couche 14 obtenue lors d'un essai réalisé en mettant en oeuvre seulement les étapes 50, 60, 100 du procédé de la figure 1. L'épaisseur de la couche 62 est d'environ 100 nm dans cet essai.

La figure 11 représente une image en coupe de la couche 62 sur la couche 14 obtenue lors d'un essai réalisé en mettant en oeuvre le même procédé que celui mis en oeuvre pour obtenir la couche 62 de la figure 10, sauf que l'étape 60 a été remplacée par une simple étape de nettoyage de la face de la couche 14 avec de l'acide fluorhydrique. Ainsi, contrairement au procédé de la figure 1, aucun atome d'argon n'est incorporé en surface de la couche 14 avant le dépôt du siliciure de vanadium. Dans ce cas, en absence d'atome d'argon incorporé en surface de la couche 14, lors de l'étape 100 de traitement thermique, la partie inférieure 62B de la couche 62 réagit avec le silicium de la couche 14. Dans cette partie inférieure, le traitement thermique de l'étape 100 transforme le siliciure de vanadium en di-siliciure de vanadium, c'est-à-dire en un composant dont la formule chimique est VSi₂. La partie supérieure 62A de la couche 62 reste quant à elle en siliciure de vanadium avec la composition V₃Si. Le problème rencontré est que le VSi₂ n'est pas un matériau supraconducteur. Ainsi, la partie supérieure 62B se trouve séparée de la couche 14 par un matériau non-supraconducteur, ce qui dégrade très fortement les performances du dispositif fabriqué.

A l'inverse, lorsque des atomes d'argon sont incorporés en surface de la couche 14, lors de l'étape 100, aucune transformation décelable de siliciure de vanadium en VSi₂ ne se produit. Dans ce dernier cas, la couche en siliciure de vanadium supraconducteur réalisée est bien directement en contact avec la couche 14. Ceci est important, par exemple, pour obtenir une bonne jonction Josephson.

### Chapitre II - Variantes :

D'autres modes de réalisation de la couche 32 sont possibles. Par exemple, en variante, la couche 32 est formée d'une sous-couche de nitrure de silicium et d'une sous-couche d'oxyde de silicium. La sous-couche en nitrure de silicium se trouve sous la sous-couche d'oxyde de silicium. Elle est donc notamment interposée entre la couche 14 est la sous-couche d'oxyde de silicium. La sous-couche de nitrure de silicium est utilisée pour contrôler la profondeur des trous 42 et 44 qui sont creusés ultérieurement principalement dans la sous-couche d'oxyde de silicium, par exemple, par gravure plasma. Dans ce dernier cas, la sous-couche en nitrure de silicium est connue sous l'acronyme CESL (Contact Etch Stop Layer).

D'autres machines à plasma que celle utilisée par le déposant peuvent convenir pour incorporer les atomes d'argon en surface de la couche 14. Dans le cas où une autre machine est utilisée, celle-ci doit être réglée pour obtenir la concentration souhaitée d'atomes d'argon en surface de la couche 14. Par exemple, un tel réglage peut être déterminé expérimentalement en mesurant pour différents réglages essayés, à chaque fois la concentration d'atomes d'argon en surface de la couche 14. Par exemple, la concentration d'atomes d'argon en surface de la couche 14 peut être mesurée par spectrométrie d'émission et, en particulier, par spectrométrie de masse à plasma à couplage inductif plus connue sous l'acronyme ICP-MS (Inductively Coupled Plasma Mass Spectrometry). La concentration d'atomes d'argon peut aussi être mesurée par d'autres procédés appropriés comme la spectrométrie photoélectronique X plus connue sous l'acronyme XPS (X-Ray photoelectron spectrometry).

Avantageusement, l'opération de traitement de la face supérieure de la couche 14 avec un plasma d'argon est précédée par une opération de nettoyage de cette face supérieure avec de l'acide fluorhydrique.

D'autres méthodes sont possibles pour incorporer des atomes d'argon en surface de la couche 14 de silicium. Par exemple, dans un autre mode de réalisation, la même méthode que celle utilisée pour implanter des dopants dans un matériau semi-conducteur est utilisée pour implanter des atomes d'argon. Dans ce cas, les atomes d'argon sont d'abord ionisés. Ensuite, les ions d'argon obtenus sont accélérés par un champ électrique puis projetés sur la face supérieure de la couche 14. L'énergie des ions d'argon est réglée pour que la majorité de ces ions ne s'enfoncent pas de plus de 5 nm ou de 10 nm à l'intérieur de la couche en silicium. Ainsi à titre d'exemple, l'énergie des ions d'argon est comprise entre 5 et 15 keV. La dose nécessaire pour obtenir une concentration atomique d'argon comprise entre 1 % atomique et 10 % atomique est comprise entre 9 x 10¹⁴ et 9 x 10¹⁵ ions par centimètre carré. Dans un exemple précis la dose nécessaire à l'obtention d'une concentration atomique d'argon de 4 % atomique est de 3.6 x 10¹⁵ ions par centimètre carré sous une énergie de 10 keV. Une fois implantés dans la couche en silicium, les ions argon redeviennent des atomes neutres d'argon. De préférence, dans ce cas, après l'implantation des atomes d'argon dans la couche en silicium, une opération de nettoyage de la face supérieure de la couche en silicium est exécutée afin de finaliser sa préparation pour le dépôt du siliciure de vanadium. Ce nettoyage a notamment pour but de désoxyder la face supérieure de la couche en silicium. Par exemple, il s'agit d'un nettoyage HF, c'est-à-dire d'un nettoyage avec de l'acide fluorhydrique ou d'un nettoyage avec un plasma d'hélium ou d'argon. Lorsque le plasma d'argon est seulement utilisé pour nettoyer la face de la couche en silicium, la pression partielle et la puissance RF n'ont pas besoin d'être réglées comme décrit précédemment pour incorporer des atomes d'argon à l'intérieur de la couche 14 de silicium. Par exemple, la pression partielle d'argon et/ou la puissance RF sont beaucoup plus faibles.

Pour incorporer des atomes d'argon en surface de la couche 14 en silicium, il est aussi possible d'exposer la face supérieure de cette couche à un gaz neutre d'argon pour que des atomes d'argon soient adsorbés sur cette face supérieure. Ensuite, un traitement thermique est appliqué pour faire diffuser les atomes d'argon adsorbés à l'intérieur de la couche en silicium.

D'autres procédés que le procédé PVD sont possibles pour déposer le siliciure de vanadium sur la couche 14. Par exemple, le siliciure de vanadium peut aussi être déposé sur la couche 14 par d'autres procédés de dépôt en phase vapeur comme le procédé de dépôt chimique en phase vapeur plus connu sous l'acronyme CVD ("Chemical Vapor Deposition"). Le siliciure de vanadium peut aussi être déposé en mettant en oeuvre un procédé de dépôt électrochimique.

Le procédé de réalisation du siliciure de vanadium supraconducteur sur une couche de silicium peut être mis en oeuvre dans d'autres contextes que celui de la fabrication d'un transistor JoFET. Par exemple, il peut aussi être mis en oeuvre pour fabriquer un transistor qui ne comporte pas de jonction de Josephson. Il peut aussi être mis en oeuvre pour fabriquer des composants qui ne sont pas des transistors comme par exemple le composant décrit en référence à la figure 4 dans la demande US2020287119A1.

Le procédé décrit peut aussi être mis en oeuvre pour fabriquer des composants dans lesquels la face supérieure de la couche en silicium directement en contact avec le siliciure de vanadium supraconducteur est une face verticale et non pas une face horizontale. Par exemple, le procédé décrit ici peut être mis en oeuvre pour fabriquer un composant tel que celui décrit en référence à la figure 3 ou 5 de la demande US2020287119A1. Dans ce cas, la couche de silicium est déposée en premier sur la couche d'oxyde. Ensuite, cette couche de silicium est structurée, typiquement par gravure, pour obtenir un canal en silicium ayant la forme souhaitée. De préférence, une couche supplémentaire est formée sur la face supérieure horizontale du canal en silicium pour servir de couche d'arrêt pour le polissage réalisé ensuite afin de retirer l'excès de siliciure de vanadium déposé. Les faces verticales du canal en silicium sont exposées au plasma d'argon comme précédemment décrit. Le siliciure de vanadium est ensuite déposé pour venir en contact avec les faces verticales du canal en silicium. L'excès de siliciure de vanadium qui se trouve sur le canal en silicium est ensuite retiré, par exemple, à l'aide d'un polissage mécano-chimique et en utilisant la couche supplémentaire comme couche d'arrêt pour ce polissage. Enfin, le traitement thermique de l'étape 100 est appliqué pour améliorer la température critique du siliciure de vanadium déposé.

En variante, l'étape 100 peut être exécutée à un autre moment. Par exemple, le traitement thermique peut aussi être exécuté juste après l'étape 60 et avant l'étape 70 ou avant l'étape 80 ou avant l'étape 90.

### Chapitre III - Avantages des modes de réalisation décrits :

Le fait de déposer directement du siliciure de vanadium sur la couche de silicium est avantageux par rapport au procédé qui dépose seulement du vanadium sur la couche de silicium puis qui transforme ensuite ce vanadium déposé en siliciure de vanadium à l'aide d'un traitement thermique. En particulier, le procédé de réalisation décrit ici empêche ou limite très fortement l'apparition de VSi₂ à l'interface entre le silicium et le siliciure de vanadium. Le procédé décrit ici permet aussi de déposer le vanadium et le silicium dans les proportions stoechiométriques souhaitées pour obtenir le siliciure de vanadium. Il y a donc moins de gaspillage de matière comme, par exemple, un dépôt trop important de vanadium. De plus, le dépôt de siliciure de vanadium est plus simple à mettre en oeuvre que le dépôt de vanadium pur car le siliciure de vanadium est moins sensible à l'oxydation et à la nitruration dans le cas où l'on souhaiterait l'encapsuler avec un nitrure. Le traitement thermique appliqué lors de l'étape 100 du procédé décrit ici pour augmenter la température critique du siliciure de vanadium se déroule à une température généralement moins élevée que celle nécessaire pour faire réagir le vanadium pur déposée sur la couche de silicium afin d'obtenir du siliciure de vanadium. De plus, la durée de ce traitement thermique est plus courte. Enfin, il est plus facile de maîtriser l'épaisseur de siliciure de vanadium déposé en mettant en oeuvre le procédé décrit ici que dans le cas où le siliciure de vanadium est obtenu par une réaction chimique entre du vanadium pur et une couche de silicium. En effet, cette réaction chimique consomme une partie de la couche de silicium et modifie donc l'épaisseur de la couche de vanadium.

L'utilisation d'un plasma d'argon permet, en une seule opération, de nettoyer la face supérieure de la couche 14 en silicium pour la préparer au dépôt de siliciure de vanadium et, en même temps, d'incorporer les atomes d'argon en surface de cette couche de silicium.

Le dépôt du siliciure de vanadium par le procédé PVD est simple à mettre en oeuvre.

## Revendications

1. Procédé de réalisation d'un siliciure de vanadium V₃Si supraconducteur sur une couche de silicium (14), ce procédé comportant :
- une étape (50) de traitement d'une face de la couche en silicium pour la préparer à un dépôt de siliciure de vanadium, puis
- le dépôt (60) d'une couche de siliciure de vanadium (62) sur la face préparée de la couche en silicium pour obtenir un empilement d'une couche de siliciure de vanadium directement déposée sur la couche en silicium, puis
- un recuit (100) de l'empilement qui augmente la température critique du siliciure de vanadium déposé,
**caractérisé en ce que** l'étape (50) de traitement comporte une opération d'incorporation d'atomes d'argon (52) dans la couche de silicium à travers la face de cette couche en silicium.

2. Procédé selon la revendication 1, dans lequel l'opération d'incorporation comporte l'exposition de la face de la couche de silicium (14) à un plasma d'ions d'argon

3. Procédé selon l'une quelconque des revendications précédentes, dans lequel l'opération d'incorporation génère, à l'intérieur de la couche de silicium (14), une région à l'intérieur de laquelle la concentration d'atomes d'argon (52) est comprise entre 1 % atomique et 10 % atomique.

4. Procédé selon la revendication 3, dans lequel ladite région est une fine couche superficielle s'étendant depuis la face préparée de la couche de silicium (14) jusqu'à une profondeur inférieure à 10 nm.

5. Procédé selon l'une quelconque des revendications précédentes, dans lequel la couche de siliciure (62) de vanadium est déposée (60) sur la face de la couche en silicium (14) par un procédé de dépôt choisi dans le groupe constitué d'un dépôt en phase vapeur et d'un dépôt électrochimique.

6. Procédé selon la revendication 5, dans lequel le procédé de dépôt est un procédé de dépôt physique en phase vapeur.

7. Procédé selon l'une quelconque des revendications précédentes, dans lequel lors du recuit (100) de l'empilement, la température est comprise entre 500°C et 900°C.

8. Procédé selon la revendication 7, dans lequel la durée du recuit est comprise entre 10 s et 5 min.

9. Procédé de fabrication d'un transistor, ce procédé comportant :
- la réalisation (10) d'une couche en silicium, puis
- la réalisation (60,100) d'une première et d'une seconde électrodes en siliciure de vanadium supraconducteur, chacune de ces première et seconde électrodes ayant une face directement en contact avec une face correspondante de la couche en silicium et étant électriquement raccordées l'une à l'autre par l'intermédiaire d'un canal formé dans la couche en silicium (14),
**caractérisé en ce que** la réalisation de chacune des première et seconde électrodes comporte la réalisation d'un siliciure de vanadium supraconducteur sur la couche de silicium en mettant en oeuvre un procédé conforme à l'une quelconque des revendications précédentes.

10. Procédé selon la revendication 9, dans lequel le procédé comporte la réalisation (10) d'une grille de commande (12) au-dessus du canal formé dans la couche de silicium (14).

## Patentansprüche

1. Verfahren zur Herstellung eines supraleitenden Vanadiumsilizids V₃Si auf einer Siliziumschicht (14), wobei dieses Verfahren umfasst:
- einen Schritt (50) des Behandelns einer Seite der Siliziumschicht, um sie auf ein Abscheiden von Vanadiumsilizid vorzubereiten, dann
- das Abscheiden (60) einer Vanadiumsilizidschicht (62) auf der vorbereiteten Seite der Siliziumschicht, um einen Stapel aus einer direkt auf der Siliziumschicht abgeschiedenen Vanadiumsilizidschicht zu erhalten, dann
- ein Glühen (100) des Stapels, das die kritische Temperatur des abgeschiedenen Vanadiumsilizids erhöht,
**dadurch gekennzeichnet, dass** der Schritt (50) des Behandelns einen Vorgang des Einbauens von Argon-Atomen (52) in die Siliziumschicht durch die Seite dieser Siliziumschicht hindurch umfasst.

2. Verfahren nach Anspruch 1, bei dem der Vorgang des Einbauens das Aussetzen der Seite der Siliziumschicht (14) gegenüber einem Plasma aus Argon-Ionen umfasst.

3. Verfahren nach einem der vorhergehenden Ansprüche, bei dem der Vorgang des Einbauens in der Siliziumschicht (14) eine Region erzeugt, in der die Konzentration der Argon-Atome (52) zwischen 1 Atom-% und 10 Atom-% beträgt.

4. Verfahren nach Anspruch 3, bei dem die Region eine dünne oberflächliche Schicht ist, die sich von der vorbereiteten Seite der Siliziumschicht (14) aus bis in eine Tiefe von weniger als 10 nm erstreckt.

5. Verfahren nach einem der vorhergehenden Ansprüche, bei dem die Vanadiumsilizidschicht (62) auf der Seite der Siliziumschicht (14) mit einem Abscheidungsverfahren abgeschieden (60) wird, das aus der Gruppe gewählt ist, die aus einer Dampfphasenabscheidung und einer elektrochemischen Abscheidung gebildet wird.

6. Verfahren nach Anspruch 5, wobei das Abscheidungsverfahren ein physikalisches Dampfphasenabscheidungsverfahren ist.

7. Verfahren nach einem der vorhergehenden Ansprüche, bei dem die Temperatur beim Glühen (100) des Stapels zwischen 500 °C und 900 °C beträgt.

8. Verfahren nach Anspruch 7, bei dem die Dauer des Glühens zwischen 10 s und 5 min beträgt.

9. Verfahren zur Fertigung eines Transistors, wobei dieses Verfahren umfasst:
- das Herstellen (10) einer Siliziumschicht, dann
- das Herstellen (60,100) einer ersten und einer zweiten Elektrode aus supraleitendem Vanadiumsilizid, wobei jede dieser ersten und zweiten Elektroden eine Seite hat, die direkt in Kontakt mit einer entsprechenden Seite der Siliziumschicht ist, und wobei sie über einen in der Siliziumschicht (14) gebildeten Kanal elektrisch miteinander verbunden sind, **dadurch gekennzeichnet, dass** die Herstellung jeder der ersten und zweiten Elektroden die Herstellung eines supraleitenden Vanadiumsilizids auf der Siliziumschicht umfasst, indem ein Verfahren nach einem der vorhergehenden Ansprüche durchgeführt wird.

10. Verfahren nach Anspruch 9, wobei das Verfahren die Herstellung (10) eines Steuergates (12) über dem in der Siliziumschicht (14) gebildeten Kanal umfasst.

## Claims

1. Method for producing a superconducting vanadium silicide V₃Si on a silicon layer (14), this method comprising:
- a stage (50) of treatment of a face of the silicon layer in order to prepare it for a deposition of vanadium silicide, then
- the deposition (60) of a vanadium silicide layer (62) on the prepared face of the silicon layer in order to obtain a stack of a vanadium silicide layer directly deposited on the silicon layer, then
- an annealing (100) of the stack which increases the critical temperature of the vanadium silicide deposited,
**characterized in that** the treatment stage (50) comprises an operation of incorporation of argon atoms (52) in the silicon layer through the face of this silicon layer.

2. Method according to Claim 1, in which the incorporation operation comprises the exposure of the face of the silicon layer (14) to a plasma of argon irons.

3. Method according to either one of the preceding claims, in which the incorporation operation generates, inside the silicon layer (14), a region inside which the concentration of argon atoms (52) is of between 1 atom% and 10 atom%.

4. Method according to Claim 3, in which said region is a fine surface layer extending from the prepared face of the silicon layer (14) down to a depth of less than 10 nm.

5. Method according to any one of the preceding claims, in which the vanadium silicide layer (62) is deposited (60) on the face of the silicon layer (14) by a deposition method chosen from the group consisting of a vapour deposition and of an electrochemical deposition.

6. Method according to Claim 5, in which the deposition method is a physical vapour deposition method.

7. Method according to any one of the preceding claims, in which, during the annealing (100) of the stack, the temperature is of between 500°C and 900°C.

8. Method according to Claim 7, in which the duration of the annealing is of between 10 s and 5 min.

9. Method for the manufacture of a transistor, this method comprising:
- the production (10) of a silicon layer, then
- the production (60,100) of a first and of a second electrode made of superconducting vanadium silicide, each of these first and second electrodes having a face directly in contact with a corresponding face of the silicon layer and being electrically connected to one another via a channel formed in the silicon layer (14), **characterized in that** the production of each of the first and second electrodes comprises the production of a superconducting vanadium silicide on the silicon layer by employing a method in accordance with any one of the preceding claims.

10. Method according to Claim 9, in which the method comprises the production (10) of a control gate (12) above the channel formed in the silicon layer (14).
